# EUROPÄISCHE PATENTSCHRIFT

(11) **EP 0 957 635 B1**
(45) Veröffentlichungstag und Bekanntmachung des Hinweises auf die Patenterteilung: **07.10.2009**
(21) Anmeldenummer: 99201434.0
(22) Anmeldetag: 07.05.1999
(51) Int. Cl.: H04N 5/60

(54) **Filterschaltung**
Filtering circuit
Circuit de filtrage

(30) Priorität: 15.05.1998 DE 19821940; 14.08.1998 DE 19836908
(43) Veröffentlichungstag der Anmeldung: 17.11.1999
(73) Patentinhaber: NXP B.V., 5656 AG Eindhoven (NL)
(72) Erfinder: Kattner, Axel, c/o Philips Patentverwaltung GmbH, 22335 Hamburg (DE); Brilka, Joachim, c/o Philips Patentverwaltung GmbH, 22335 Hamburg (DE)
(74) Vertreter: Krott, Michel

(56) Entgegenhaltungen:
- DE-A- 3 411 791
- PATENT ABSTRACTS OF JAPAN vol. 014, no. 082 (E-0889), 15. Februar 1990 (1990-02-15) & JP 01 293777 A (MITSUBISHI ELECTRIC CORP), 27. November 1989 (1989-11-27)

## Beschreibung

Die Erfindung betrifft eine Filterschaltung zur Filterung wenigstens eines Tonträgers in einem Composite-Video-Signal mittels wenigstens eines Signalfilters, das wenigstens eine Filterfrequenz aufweist, welche in Abhängigkeit eines Steuersignals einstellbar ist.

Bei derartigen Filterschaltungen stellt sich das Problem, daß für Composite-Video-Signalen verschiedener Normen die Frequenz des Tonträgers in etwa in einem Bereich zwischen 4,5 und 6,5 MHz verschiedene Werte annehmen kann. Die Schaltung ist daher so auszulegen, daß sie diese verschiedenen Tonträgerfrequenzen ausfiltern kann. Dazu können Keramikfilter eingesetzt werden, zwischen denen je nach Übertragungsnorm umgeschaltet wird; eine derartige Schaltung ist jedoch sehr aufwendig.

Aus der US 5,239,367 ist eine Filterschaltung für ein Videosignal bekannt, deren Frequenz in Abhängigkeit davon, ob es sich um ein PAL- oder ein NTSC-Videosignal handelt, umgeschaltet werden kann. Dafür wird ein Referenzfilter eingesetzt, das auf einer Referenzfrequenz arbeitet und dessen Ausgangssignal einem Phasendiskriminator zugeführt wird, dem ebenfalls das Referenzsignal an einem weiteren Eingang zugeführt wird. In Abhängigkeit der Phasenlage der beiden dem Phasendiskriminator zugeführten Signale wird mittels des Ausgangssignals des Phasendiskrminators die Filterfrequenz des Referenzfilters so nachgestimmt, daß das Filter auf die Referenzfrequenz des Referenzsignals abgestimmt wird. In diesem Zustand dreht das Referenzfilter die Phasenlage des ihm zugeführten Referenzsignals gerade um einen solchen Wert, daß keine weitere Nachstimmung mehr stattfindet. Dasjenige Signal, mit dem das Referenzfilter nachgestimmt wird, wird zur Betätigung eines Umschalters verwendet, der verschiedene Stromquellen auf das Signalfilter schaltet, wodurch dessen Filterfrequenz umgeschaltet wird.

Abgesehen davon, daß die Frequenzlage des Signalfilters dieser Schaltung nur zwischen zwei Frequenzlagen umschaltbar ist und daß die Schaltung letztlich mehr der Erkennung der PAL\NTSC-Norm und der entsprechenden Umschaltung des Signalfilters dient, weist sie darüber hinaus den Nachteil auf, dass die Schaltung nur für eine bestimmte Prozesslage optimiert sein kann. Durch die Umschaltung auf verschiedene Frequenzen arbeitet das Referenzfilter in anderer Frequenzlage als das Signalfilter. Ferner kann die gesamte Schaltung nur für eine bestimmte Temperatur optimiert sein; durch Änderung der Chip-Temperatur treten Streuungen der Frequenzlage des Signalfilters nach wie vor ein und können die Schaltung unbrauchbar machen.

Es ist Aufgabe der Erfindung, eine Filterschaltung der eingangs genannten Art anzugeben, bei der das Signalfilter auch unter Berücksichtigung von Streuungen des Herstellungsprozesses der Schaltung, unabhängig von der Temperatur, mit der die Schaltung betrieben wird und unabhängig von der Frequenzlage des Signalfilters auf einer einstellbaren Soll-Signal-Frequenz arbeitet.

Diese Aufgabe ist erfindungsgemäß dadurch gelöst, dass als Referenzsignal ein Ausgangssignal eines gesteuerten Oszillators eines Phasenregelkreises eingesetzt wird, welcher der Demodulation eines dem Tonträger aufmodulierten Tonsignals dient und dessen gesteuerter Oszillator im gerasteten Zustand des Phasenregelkreises ein Ausgangssignal mit der Frequenz des Tonträgers liefert.

Das Referenzfilter, dem das Referenzsignal zugeführt wird, dreht dieses bei Abstimmung der Filterfrequenz auf die Frequenz dieses Referenzsignals um einen definierten Wert. Dem Phasenkomparator wird sowohl das bezüglich seiner Phase gedrehte Referenzsignal wie auch das Original-Referenzsignal zugeführt, Das Ausgangssignal des Phasenkomparators wird dazu herangezogen, das Referenzfilter nachzustimmen. Dasselbe Steuersignal wird ebenfalls dazu herangezogen, das Signalfilter bezüglich seiner Filterfrequenz kontinuierlich nachzustimmen. Dabei ist dieses Signal so ausgelegt, daß das Referenzfilter auf die Frequenz des ihm zugeführten Signals abgestimmt wird. Es werden damit also Streuungen, Temperaturschwankungen etc. ausgeglichen und durch die Nachstimmung des Referenzfilters kompensiert. In entsprechender Weise wird auch das Signalfilter nachgeführt.

Bei den nach dem Stande der Technik bekannten Schaltungen kann eine derartige Schaltung immer nur für eine Frequenzlage optimiert sein. Soll hingegen das Signalfilter auf verschiedenen Frequenzen arbeiten, die gegebenenfalls von der Arbeitsfrequenz des Referenzfilters abweichen, so wirken sich äußere Auswirkungen auf die Schaltung im Verhältnis der Frequenz des Signalfilters zu der Frequenz des Referenzfilters aus. Damit treten je nach Arbeitsfrequenz des Signalfilters diese Auswirkungen unterschiedlich bei den beiden Filtern auf, so daß das Signalfilter nicht mehr optimal nachgestimmt werden kann. Auch Prozeßstreuungen an Temperatur wirken sich auf die Frequenzlage der Signalfilter aus; arbeitet das Signalfilter auf einer anderen Frequenz als das Referenzfilter, so sind auch diese Auswirkungen auf die Filter verschieden, so daß eine optimale Nachstimmung nicht mehr möglich ist.

Zur weitgehenden Beseitigung dieser Nachteile wird als Referenzsignal das Ausgangssignal eines gesteuerten Oszillators eines Phasenregelkreises eingesetzt. Diesem Phasenregelkreis wird das Composite-Video-Signal zugeführt, das auch dem Signalfilter der Filterschaltung zugeführt wird. Dieser Phasenregelkreis dient der Demodulation des dem Tonträger aufmodulierten Tonsignals. Damit arbeitet dieser Phasenregelkreis im gerasteten Zustand auf der Frequenz des Tonträgers. Somit liefert der spannungsgesteuerte Oszillator dieses Phasenregelkreises ein Signal, das exakt der Frequenz des auszufilternden Tonträgers in dem Composite-Video-Signal entspricht.

Dadurch, daß dieses Signal als Referenzsignal für das Referenzfilter benutzt wird, wird erreicht, daß sowohl das Referenzfilter wie auch das Signalfilter immer auf der gleichen Frequenz arbeiten, nämlich auf der Frequenz des auszufilternden Tonträgers. Damit wirken sich die oben beschriebenen Auswirkungen, Prozeßstreuungen und Temperaturschwankungen auf beide Filter in gleicher Weise aus. Damit gelingt nicht nur die Nachstimmung des Referenzfilters unter verschiedenen äußeren Einwirkungen optimal, sondern auch die des Signalfilters, da dieses auf der gleichen Filterfrequenz arbeitet.

Damit ist im Ergebnis erreicht worden, daß die Filterschaltung auch bei verschiedenen Filterfrequenzen immer optimal arbeitet, d.h. daß das Signalfilter immer optimal auf die Frequenz des auszufilternden Tonträgers einstellbar ist. Ferner wird der Vorteil erreicht, daß ein zusätzliches Schaltsignal für das Umschalten des Signalfilters nicht mehr erzeugt werden muß.

Diese Vorteile können gegebenenfalls noch dadurch gesteigert werden, daß entsprechend den Merkmalen nach Anspruch 2 sowohl das Referenzfilter wie auch das Signalfilter in gleicher Technik aufgebaut werden, so daß sich Prozeßstreuungen, Temperaturschwankungen und andere Einwirkungen auf beide Filter in gleicher Weise auswirken.

Die Generierung des Steuersignals aus dem Ausgangssignal des Phasenkomparators kann vorzugsweise entsprechend den Merkmalen des Anspruches 3 vorgenommen werden, welche eine einfache Schaltung zur Erzeugung des Steuersignals beinhalten.

Der Phasenregelkreis, aus dem das Referenzsignal gewonnen wird, kann vorzugsweise, wie gemäß Anspruch 4 vorgesehen, ein Schmalband-Phasenregelkreis sein, welcher keine Amplitudenbegrenzung, sondern eine Amplitudenregelung aufweist und der so ausgelegt ist, daß er eine eigene Selektivität aufweist.

Sollte beispielsweise in dem Composite-Video-Signal kein Tonträger enthalten sein, so kann der Phasenregelkreis auch auf keinen derartigen Tonträger rasten. In diesem Falle ist es vorteilhaft, wie gemäß einer weiteren Ausgestaltung gemäß Anspruch 5 vorgesehen ist, die Frequenz des gesteuerten Oszillators des Phasenregelkreises mittels einer Nachstimmschaltung in einem Soll-Frequenzbereich zu halten. Damit wird für die erfindungsgemäße Filterschaltung erreicht, daß in einem derartigen Fall das Signalfilter ebenfalls in einem Soll-Frequenzbereich gehalten wird.

Eine weitere Ausgestaltung der Erfindung gemäß Anspruch 7 sieht vor, sowohl für das Signalfilter wie auch für das Referenzfilter Integrator-Filter einzusetzen. Deren Integrator-Elemente sind vorteilhaft in gleicher Technik aufgebaut. Selbst wenn es sich um Filter verschiedener Ordnung handeln sollte, treten dann die oben beschriebenen Einwirkungen auf die Filter in gleicher Weise auf.

Nachfolgend wird anhand der Zeichnung ein Ausführungsbeispiel der Erfindung näher erläutert. Es zeigen:
Fig. 1 ein Ausführungsbeispiel einer erfindungsgemäßen Filterschaltung ohne Generierung des Referenzsignals und
Fig. 2 ein Übersichtsschaltbild eines TV-Empfängers mit einem Video-Demodulator, der Filterschaltung gemäß Fig. 1 und eines Phasenregelkreises zur Demodulation der Tonsignale und zur Gewinnung des Referenzsignals.

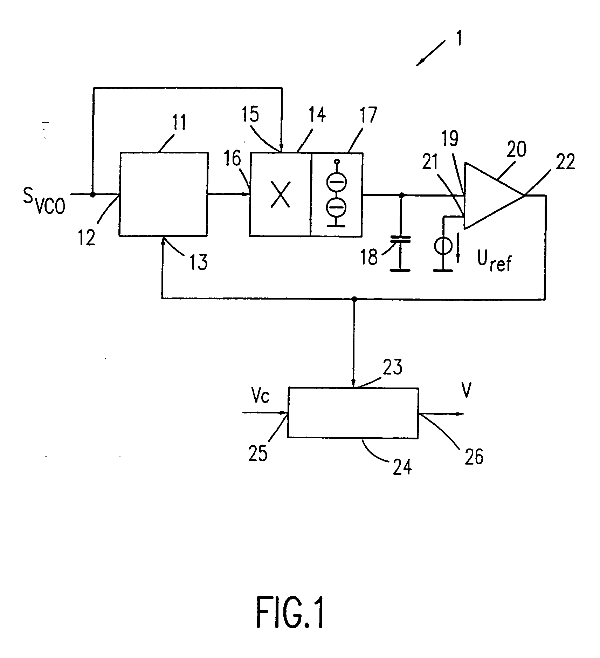

Ein in Fig. 1 dargestelltes Prinzip-Schaltbild einer erfindungsgemäßen Filterschaltung 1 zeigt diese Schaltung mit allen wesentlichen Elementen, jedoch ohne den Phasenregelkeis zur Gewinnung des Referenzsignals.

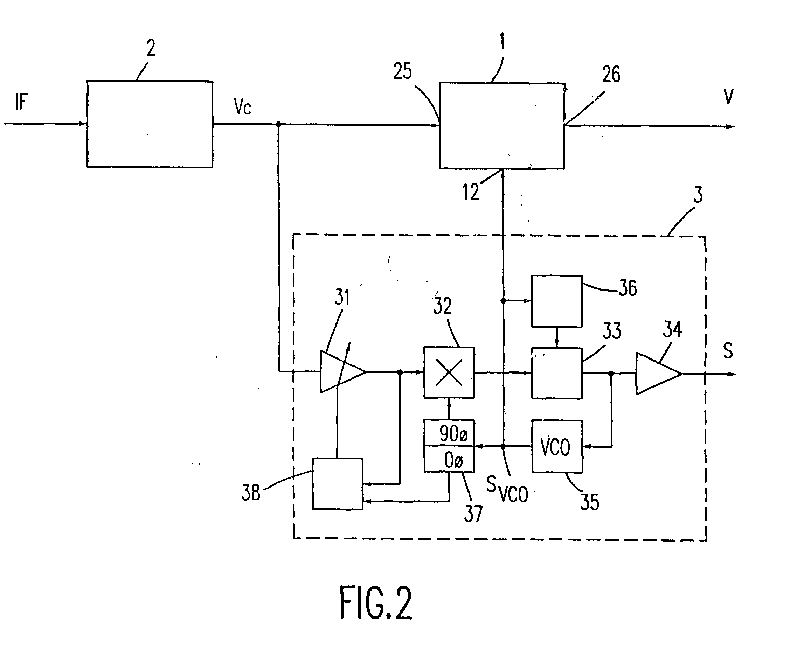

Die Filterschaltung 1 weist ein Referenzfilter 11 auf, dem an einem ersten Eingang 12 ein Referenzsignal S_{VCO} zugeführt wird. Dieses Signal stammt von einem Phasenregelkreis, der unten anhand von Fig. 2 näher erläutert werden wird.

Dem Referenzfilter 11 ist ein Phasenregelkreis 14 nachgeschaltet, dem an einem ersten Eingang 15 das unveränderte Referenzsignals S_{VCO} zugeführt wird. Einem zweiten Eingang 16 des Phasendiskriminators 14 wird das Ausgangssignal des Referenzfilters 11 zugeführt.

Das Ausgangssignal des Phasendiskriminators 14 wird zur Steuerung einer bidirektionalen Stromquelle 17 eingesetzt, welche in Abhängigkeit von Vorzeichen und Größe des Ausgangssignals des Phasendiskriminators 14 Ströme verschiedenen Vorzeichens und verschiedenen Betrages liefert. Diese Ströme gelangen auf einen Kondensator 18, der dadurch geladen oder entladen wird. Die über dem Kondensator 18 abfallende Spannung gelangt an einen ersten Eingang 19 eines Komparators 20, dem an einem zweiten Eingang 21 eine Referenzspannung U_{ref} zugeführt wird. An seinem Ausgang 22 liefert der Komparator 20 ein Steuersignal, welches einem Steuereingang 13 des Referenzfilters 11 zugeführt wird. In Abhängigkeit dieses Steuersignals wird die Filterfrequenz des Referenzfilters 11 eingestellt.

Das Steuersignal wird ferner einem Steuereingang 23 eines Signalfilters 24 zugeführt. Auch die Filterfrequenz dieses Signalfilters 24 ist in Abhängigkeit des Steuersignals einstellbar. Das Signalfilter 24 dient zur Ausfilterung eines oder mehrerer Tonträger, die in einem Composite-Video-Signal enthalten sind. Dabei befindet sich die Videokomponente des Composite-Video-Signals im Basisband; der Tonträger auf einer zweiten Tonträger-Zwischenfrequenz.

Dem Signalfilter 24 wird eingangsseitig das Composite-Video-Signal V_{C} an einem Eingang 25 zugeführt. An einem Ausgang 26 liefert das Signalfilter 24 das gefilterte Signal, in dem der Tonträger nicht mehr enthalten ist und das in der Figur 1 mit V bezeichnet ist.

Die Arbeitsweise dieser Schaltung ist dadurch geprägt, daß die Filterfrequenz des Referenzfilters in Abhängigkeit des Steuersignals immer so nachgeführt wird, daß sie der Frequenz des Referenzsignals S_{VCO} entspricht. Es wird damit dann auch in Abhängigkeit des Steuersignals die Filterfrequenz des Signalfilters 24 entsprechend eingestellt.

Dies wird durch folgende Arbeitsweise erreicht:

Das Referenzfilter 11 ist so ausgelegt, daß es das ihm zugeführte Signal bei Abstimmung seiner Filterfrequenz auf die Frequenz dieses Signals bezüglich seiner Phase um einen definierten Wert dreht, vorzugsweise um den Wert 90°. Ist dieser Wert in den Eingangssignalen des Phasendiskriminators 14 erreicht, so erreicht dessen Ausgangssignal den Wert Null, so daß die bidirektionale Stromquelle 17 nicht angesteuert wird. Weicht hingegen die Phasenabweichung von dem vorgegebenen Wert, beispielsweise von 90°, ab, so wird der Phasendiskriminator 14 ein entsprechendes Ausgangssignal liefern, das je nach Vorzeichen der Phasenabweichung die bidirektionale Stromquelle 17 ansteuert, so daß je nach Vorzeichen der Phasenabweichung der Kondensator 18 entweder geladen oder entladen wird. Es tritt damit am Eingang 19 des Komparators 20 eine entsprechend höhere oder niedrigere Spannung auf. Nach Vergleich mit der Referenzspannung, die liefert der Komparator 20 ein Ausgangssignal, das ein Maß dafür ist, inwieweit die Phasenlage des Ausgangssignals des Referenzfilters von der vorgegebenen Soll-Phasenlage abweicht. Dies ist gleichzeitig ein Maß dafür, inwieweit die Filterfrequenz des Referenzfilters nicht exakt auf die Frequenz des Referenzsignals S_{VCO} abgestimmt ist. Somit kann mittels des Steuersignals das Referenzfilter so nachgestimmt werden, bis die Sollphasenbeziehung wieder hergestellt ist, bis also das Referenzfilter exakt auf die Frequenz des Referenzsignals S_{VCO} abgestimmt ist und ausgangsseitig ein Signal mit der Soll-Phasenverschiebung liefert.

Auf diese Weise kann das Referenzfilter bezüglich seiner Filterfrequenz laufend so nachgeregelt werden, daß es mit der Frequenz des Referenzsignals übereinstimmt. Damit können äußere Einwirkungen, Prozeßstreuungen und Temperatureinflüsse ausgeregelt werden. In entsprechender Weise wird durch das Steuersignal auch das Signalfilter 24 bezüglich seiner Filterfrequenz nachgeregelt.

Es besteht jedoch zur Filterung der Composite-Video-Signale V_{C} gegebenenfalls der Wunsch in Signalen verschiedener Übertragungsnormen Tonträger verschiedener Frequenzen auszufiltern. Dies bedeutet, daß das Signalfilter 24 auf verschiedene Frequenzen abgestimmt werden muß. Dies könnte im einfachsten Fall dadurch geschehen, daß dem dem Signalfilter 24 zugeführten Steuersignal Schaltanteile überlagert werden, die eine entsprechende Verstimmung des Signalfilters bewirken. Damit trete jedoch der Nachteil ein, daß die oben beschriebenen Einwirkungen auf das Signalfilter in anderer Weise stattfänden als auf das Referenzfiltern, da das Signalfilter mit anderer Frequenz arbeitet. Tatsächlich würden sich diese im Verhältnis der Frequenzen von Signalfilter zu Referenzfilter auswirken. Somit wäre das Signalfilter nicht mehr exakt auf die Frequenz des jeweiligen Tonträgers abgestimmt.

Zur Lösung dieses Problems ist erfindungsgemäß vorgesehen, daß das Referenzfilter 11 und das Signalfilter 24 auf der gleichen Frequenz arbeiten. Dies wird dadurch erreicht, daß als Referenzsignal S_{VCO} ein Ausgangssignal eines Phasenregelkreises eingesetzt wird, welcher der Demodulation des dem Tonträger aufmodulierten Tonsignals dient. Dieses Signal hat zwangsläufig die Frequenz des Tonträgers und wird als Referenzsignal eingesetzt. Damit hat das Referenzsignal die gleiche Frequenz wie derjenige Tonträger in dem Composite-Video-Signal V_{C}, der mittels des Signalfilters 24 auszufiltern ist. Somit arbeiten im abgestimmten Zustand beide Filter auf der gleichen Frequenz, so daß sich die oben genannten Einwirkungen auf beide Filter in gleicher Weise auswirken.

In Fig. 2 ist teilweise im Blockschaltbild teilweise in detaillierterer Form eine Eingangsschaltung eines TV-Empfängers dargestellt, in welcher ein Phasenregelkreis 3 angedeutet ist, dessen Signal als Referenzsignal S_{VCO} in der Filterschaltung gemäß Fig. 1 eingesetzt wird.

Der Gesamtanordnung gemäß Fig. 2 wird eingangsseitig ein Zwischenfrequenz-Video-Signal IF zugeführt. In diesem Signal ist eine Videokomponente und eine Tonträgerkomponente, welche beide in Zwischenfrequenzlage auftreten. Dieses Signal wird einem Demodulator 2 zugeführt, der dieses Signal in ein Composite-Video-Signal umsetzt, in welchen das Videosignal in Basisbandlage und der Tonträger auf einer zweiten Tonträger-Zwischenfrequenz auftreten.

Bei diesem Signal handelt es sich um dasjenige Signal, das mittels der Filterschaltung gemäß Fig. 1 bzw. mittels des in dieser Schaltung vorgesehenen Signalfilters 24 in der Weise ausgefiltert werden soll, daß der Tonträger in diesem Signal unterdrückt wird. Dazu wird dieses Signal gemäß der Darstellung in Fig. 2 der Filterschaltung 1 am Eingang 25 dessen Signalfilters zugeführt. Ausgangsseitig liefert die Filterschaltung 1 am Ausgang 26 dessen Signalfilters das ausgefilterte Videosignal V, in dem der oder die Tonträger unterdrückt sind.

Das Composite-Video-Signal, das von dem Demodulator 2 geliefert wird, wird außerdem einem Schmalband-Phasenregelkreis 3 zugeführt, der der Demodulation des oder der Tonsignale, die dem oder den Tonträgern aufmoduliert sind, dient. Der Schmalband-Phasenregelkreis 3 liefert ausgangsseitig ein oder mehrere demodulierte Tonsignale S.

Ein Schmalband-Phasenregelkreis weist eine eigene Selektivität auf. Dies wird im wesentlichen dadurch erreicht, daß keine Amplitudenbegrenzung des ihm zugeführten Signals vorgenommen wird, sondern statt dessen eine Amplitudenregelung. Ferner wird der spannungsgesteuerte Oszillator des Phasenregelkreises in einem Soll-Frequenzbereich gehalten, so daß im nicht gerasteten Zustand des Phasenregelkreises dieser in eben diesem Soll-Frequenzbereich gehalten wird.

In der Darstellung gemäß Fig. 2 wird das Composite-Video-Signal V_{C} einem regelbaren Verstärker 31 zugeführt, dem ein Phasendiskriminator 32 nachgeschaltet ist. Das Ausgangssignal des Phasendiskriminator 32 gelangt auf ein Schleifenfilter 33, dem ein Verstärker 34 nachgeschaltet ist, der das demodulierte Tonsignal S liefert.

Ferner gelangt das Ausgangssignal des Schleifenfilters 33 auf einen spannungsgesteuerten Oszillator 35, welcher ein Ausgangssignal liefert, das einer Schaltung 37 zur Phasenverschiebung zugeführt wird. Die Schaltung 37 hat zwei Ausgänge, von denen an einem ersten Ausgang das Signal S_{VCO} in nicht verschobener Phasenlage auftritt, welches einer Regelschaltung 38 zugeführt wird. Ferner liefert die Schaltung 37 ein um 90° verschobenes Signal, welches einem zweiten Eingang des Phasendiskriminators 32 zugeführt wird.

Der Regelschaltung 38, welche den steuerbaren Verstärker 31 ansteuert und dessen Ausgangssignal in einem Soll-Amplitudenbereich hält, wird ferner an einem weiteren Eingang das Ausgangssignal des steuerbaren Verstärkers 31 zugeführt.

Es ist ferner eine Grenzenerkennungsschaltung 36 vorgesehen, welcher das Ausgangssignal des spannungsgesteuerten Oszillators 35 zugeführt wird und welche ein Steuersignal an das Schleifenfilter 33 liefert, welches im nicht gerasteten Zustand des Schmalband-Phasenregelkreises 3 die Frequenz des spannungsgesteuerten Oszillators 35 in einem Soll-Frequenzbereich hält.

Der Schmalband-Phasenregelkreis 3 weist eine eigene Selektivität auf. Im eingeschwungenen Zustand wird durch die eingangsseitige Amplitudenregelung erreicht, daß der Schmalband-Phasenregelkreis 3 immer auf der Frequenz des Tonträgers in dem Composite-Video-Signal V_{C} schwingt. Ist kein Eingangssignal vorhanden, oder in diesem Signal kein Tonträger enthalten, wird durch die Grenzenerkennungsschaltung 36 sichergestellt, daß der S_{VCO} immer in dem Soll-Frequenzbereich arbeitet.

Das Ausgangssignal des spannungsgesteuerten Oszillators 35 liefert also immer ein Signal einer Frequenz, welches der Frequenz des Tonträgers in dem Composite-Video-Signal entspricht. Damit entspricht diese Frequenz immer der Filterfrequenz des Signalfilters 24 der Filterschaltung gemäß Fig. 1. Erfindungsgemäß wird daher das Ausgangssignal des spannungsgesteuerten Oszillators 35 als Referenzsignal 12 eingesetzt. In der Filterschaltung gemäß Fig. 1 wird dadurch erreicht, daß sowohl das Referenzfilter wie auch das Signalfilter auf der gleichen Frequenz arbeiten. Damit gelingt die Nachregelung optimal; es wird nämlich nicht nur das Referenzfilter, sondern auch das Signalfilter optimal nachgestimmt. Die oben beschriebenen Einwirkungen treten auf beide Filter in gleicher Weise ein, so daß sie für beide Filter in gleicher Weise ausgeregelt werden können. Damit wird im Ergebnis erreicht, daß das Signalfilter der Filterschaltung 1 gemäß Fig. 1 immer exakt auf die Frequenz des auszufilternden Tonträgers abgestimmt ist.

## Patentansprüche

1. Filterschaltung zur Filterung wenigstens eines Tonträgers in einem Composite-Video-Signal mittels wenigstens eines Signalfilters (24), das wenigstens eine Filterfrequenz aufweist, welche in Abhängigkeit eines Steuersignals einstellbar ist, wobei die Filterschaltung (1) ein Referenzfllter (11) aufweist, dessen Filterfrequenz in Abhängigkeit des Steuersignals einstellbar ist und das bei Abstimmung der Filterfrequenz auf die Frequenz eines ihm zugeführten Referenzsignals dieses bezüglich seiner Phase um einen definierten Wert dreht, wobei ein Phasenkomparator (14) vorgesehen ist, dem das Ausgangssignal des Referenzfilters (11) und das Referenzsignal zugeführt werden, und wobei aus dem Ausgangssignal des Phasenkomparators (14) das Steuersignal in der Weise abgeleitet wird, dass das Referenzfilter (11) auf die Frequenz des Referenzsignals abgestimmt wird, **dadurch gekennzeichnet, dass** als Referenzsignal ein Ausgangssignal eines gesteuerten Oszillators (35) eines Phasenregelkreises (3) eingesetzt wird,welcher der Demodulation eines dem Tonträger aufmodulierten Tonsignals dient und dessen gesteuerter Oszillator (35) im gerasteten Zustand des Phasenregellaeises (3) ein Ausgangssignal mit der Frequenz des Tonträgers liefert.

2. Filterschaltung nach Anspruch 1, **dadurch gekennzeichnet, dass** das Referenzfilter (11) in gleicher Technik wie das Signalfilter (24) aufgebaut ist und dass die Filterfrequenz des Referenzfilters (11) mittels des Steuersignals in gleicher Weise wie die Filterfrequenz des Signalfilters (24) beeinflussbar ist.

3. Filterschaltung nach Anspruch 1, **dadurch gekennzeichenet, dass** die Generierung des Steuersignals in der Weise vorgenommen wird, dass zwei Stromquellen oder eine bidirektionale Stromquelle (17) in Abhängigkeit des Ausgangssignals des Phasenkomparators (14) eine Kapazität (18) mit Strömen unterschiedlichen Vorzeichens laden bzw. entladen und dass ein Komparator (20) vorgesehen ist, dem an einem ersten Eingang (19) die über der Kapazität (18) abfallende Spannung und an einem zweiten Eingang (21) eine Referenzspannung zugeführt wird und der ausgangsseitig das Steuersignal liefert.

4. Filterschaltung nach einem der Ansprüche 1, **dadurch gekennzeichnet, daß** als Phasenregelkreis (3) ein Schmalband-Phasenregelkreis vorgesehen ist, welcher eine eigene Selektivität aufweist.

5. Filterschaltung nach Anspruch 1, **dadurch gekennzeichnet, daß** während solcher Zeiten, in denen kein Tonträger in dem Composite-Video-Signal enthalten ist, die Frequenz des gesteuerten Oszillators (35) des Phasenregelkreises mittels einer Nachstimmschaltung (36) in einem Soll-Frequenzbereich gehalten wird.

6. Filterschaltung nach Anspruch 1, **dadurch gekennzeichnet, daß** das Referenzfilter (11) bei Abstimmung auf die Frequenz des ihm zugeführten Referenzsignals dieses bezüglich seiner Phase um 90° dreht.

7. Filterschaltung nach Anspruch 1, **dadurch gekennzeichnet, daß** als Signalfilter (24) und als Referenzfilter (11) Integrator-Filter vorgesehen sind, welche Integrator-Elemente gleicher Bauart aufweisen.

8. Filterschaltung nach Anspruch 7, **dadurch gekennzeichnet, daß** als Signalfilter ein erstes Integrator-Filter dritter, und ein zweites und drittes Integrator-Filter jeweils zweiter Ordnung vorgesehen sind.

9. Filterschaltung nach Anspruch 7, **dadurch gekennzeichnet, daß** das erste und zweite Integrator-Filter zur Ausfilterung eines ersten Tonträgers ausgelegt sind und daß das dritte Integrator-Filter zur Ausfilterung eines zweiten Tonträgers ausgelegt ist, welcher eine kleinere Amplitude aufweist als der erste Tonträger.

## Claims

1. A filter circuit for filtering at least one sound carrier in a composite video signal by means of at least one signal filter (24) having at least one filter frequency which is adjustable in dependence upon a control signal, which filter circuit (1) comprises a reference filter (11) whose filter frequency is adjustable in dependence upon the control signal and which, when the filter frequency is tuned to the frequency of a reference signal applied to the reference filter (11), shifts the phase of this reference signal by a defined value, where a phase comparator (14) is provided to which the output signal of the reference filter (11) and the reference signal are applied,
and where the control signal is derived from the output signal of the phase comparator (14) in such a way that the reference filter (11) is tuned to the frequency of the reference signal, **characterized in that** an output signal of a controlled oscillator (35) of a phase-locked loop (3) is used as a reference signal which serves for demodulating a sound signal modulated on the sound carrier and whose controlled oscillator (35) supplies an output signal at the frequency of the sound carrier in the locked state of the phase-locked loop (3).

2. A filter circuit as claimed in claim 1, **characterized in that** the reference filter (11) is built up in the same technique as the signal filter (24) and **in that** the filter frequency of the reference filter (11) can be influenced by the control signal in the same way as the filter frequency of the signal filter (24).

3. A filter circuit as claimed in claim 1, **characterized in that** the control signal is generated in such a way that two current sources or one bidirectional current source (17) charge or discharge a capacitance (18) with currents of different signs in dependence upon the output signal of the phase comparator (14), and **in that** a comparator (20) is provided which receives the voltage across the capacitance (18) on a first input (19) and receives a reference voltage on a second input (21), and supplies the control signal on the output.

4. A filter circuit as claimed in claim 1, **characterized in that** a narrow-band phase-locked loop having its own selectivity is provided as a phase-locked loop (3).

5. A filter circuit as claimed in claim 1, **characterized in that** during those periods in which no sound carrier is present in the composite video signal, the frequency of the controlled oscillator (35) of the phase-locked loop is maintained in a nominal frequency range by means of a fine-tuning circuit (36).

6. A filter circuit as claimed in claim 1, **characterized in that** the reference filter (11) shifts the phase of the reference signal applied thereto by 90° when tuning to the frequency of said reference signal.

7. A filter circuit as claimed in claim 1, **characterized in that** integrator filters comprising integrator elements of the same construction are provided as a signal filter (24) and as a reference filter (11).

8. A filter circuit as claimed in claim 7, **characterized in that** a first third-order integrator filter and a second and third second-order integrator filter are provided as signal filters.

9. A filter circuit as claimed in claim 7, **characterized in that** the first and the second integrator filter are implemented for filtering a first sound carrier, and **in that** the third integrator filter is implemented for filtering a second sound carrier having a smaller amplitude than the first sound carrier.

## Revendications

1. Circuit de filtrage destiné à filtrer au moins un support d'enregistrement audio dans un signal vidéo composite au moyen d'au moins un filtre de signal (24) comprenant au moins une fréquence de filtrage pouvant être réglée en fonction d'un signal de commande, le circuit de filtrage (1) comprenant un filtre de référence (11) dont la fréquence de filtrage peut être réglée en fonction du signal de commande et qui tourne autour d'une valeur définie lorsque la fréquence de filtrage est adaptée à la fréquence d'un signal de référence de celui-ci amené à celui-ci par rapport à sa phase, un comparateur de phases (14) auquel le signal de sortie du filtre de référence (11) et le signal de référence sont amenés étant prévu, et le signal de commande étant déduit du signal de sortie du comparateur de phases (14) de telle sorte que le filtre de référence (11) est adapté à la fréquence du signal de référence, **caractérisé en ce qu'**un signal de sortie d'un oscillateur (35) commandé d'un circuit à verrouillage de phase (3), lequel sert à démoduler un signal sonore modulé sur le support d'enregistrement audio et dont l'oscillateur commandé (35) délivre dans l'état enclenché du circuit boucle à verrouillage de phase (3) un signal de sortie présentant la fréquence du support d'enregistrement audio, est utilisé comme signal de référence.

2. Circuit de filtrage selon la revendication 1, **caractérisé en ce que** le filtre de référence (11) présente la même structure technique que le filtre de signal (24) et **en ce que** la fréquence de filtrage du filtre de référence (11) peut être influencée au moyen du signal de commande de la même façon que la fréquence de filtrage du filtre de signal (24).

3. Circuit de filtrage selon la revendication 1, **caractérisé en ce que** la génération du signal de commande est réalisée de telle sorte que deux sources de courant ou une source de courant bidirectionnelle (17) en fonction du signal de sortie du comparateur de phases (14) chargent et/ou déchargent une capacité (18) comprenant des courants de différents signes et **en ce qu'**il est prévu un comparateur (20) auquel la tension chutant par l'intermédiaire de la capacité (18) est amenée par une première entrée (19) et auquel une tension de référence est amenée par une seconde entrée (21) et qui fournit le signal de commande côté sortie.

4. Circuit de filtrage selon l'une quelconque des revendications 1, **caractérisé en ce qu'**un circuit boucle à verrouillage de phase et à bande étroite comprenant une sélectivité distincte est prévu comme circuit boucle à verrouillage de phase (3).

5. Circuit de filtrage selon la revendication 1, **caractérisé en ce que** pendant les périodes durant lesquelles aucun support d'enregistrement audio n'est contenu dans le signal vidéo composite, la fréquence de l'oscillateur commandé (35) du circuit boucle à verrouillage de phase est maintenue au moyen d'un circuit de syntonisation (36) dans une plage de fréquence théorique.

6. Circuit de filtrage selon la revendication 1, **caractérisé en ce que** le filtre de référence (11), lorsqu'il est adapté à la fréquence du signal de référence qui lui est amené tourne de 90° par rapport à sa phase.

7. Circuit de filtrage selon la revendication 1, **caractérisé en ce que** des filtres intégrateurs, lesquels présentent des éléments intégrateurs de même type de construction, sont prévus comme filtre de signal (24) et comme filtre de référence (11).

8. Circuit de filtrage selon la revendication 7, **caractérisé en ce qu'**un premier filtre intégrateur, et un deuxième et troisième filtre intégrateur respectivement de second ordre sont prévus comme filtre de signal.

9. Circuit de filtrage selon la revendication 7, **caractérisé en ce que** le premier et le deuxième filtre intégrateur sont conçus pour filtrer un premier support d'enregistrement audio et **en ce que** le troisième filtre intégrateur est conçu pour filtrer un second support d'enregistrement audio, lequel présente une amplitude inférieure à celle du premier support d'enregistrement audio.
